Europäisches Patentamt

European Patent Office

Office européen des brevets

(19)

(11) Publication number: **0 398 216**
**A2**

# EUROPEAN PATENT APPLICATION

(21) Application number: **90109026.6**

(22) Date of filing: **14.05.90**

(51) Int. Cl.5: **H01L 21/322**

(30) Priority: **16.05.89 JP 122453/89**

(43) Date of publication of application:
**22.11.90 Bulletin 90/47**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Aoki, Masaki, c/o Fujitsu Limited**
**Patent Department, 1015 Kamikodanaka**
**Nakahara-ku, Kawasaki-shi, Kanagawa**
**211(JP)**

(74) Representative: **Sunderland, James Harry et al**
**HASELTINE LAKE & CO Hazlitt House 28**
**Southampton Buildings Chancery Lane**
**London WC2A 1AT(GB)**

(54) **Gettering heavy metal impurities.**

(57) A method of gettering heavy metal impurities combined with acceptor impurities in a silicon substrate, in which an intrinsic gettering layer and a surface denuded zone are formed and then the substrate is heated to a predetermined temperature and simultaneously irradiated with light rays. The predetermined temperature is selected to be lower than the precipitation temperature of the heavy metal impurities and high enough for the heavy metal impurities to diffuse into the intrinsic gettering layer. The energy level of the light is selected to be sufficient to dissociate the heavy metal impurities from the acceptor impurities.

EP 0 398 216 A2

## Gettering heavy metal impurities.

The present invention relates to a method of removing from a surface region of a silicon semiconductor substrate heavy metal impurities.

In general, impurities such as a small amount of oxygen or carbon are introduced into silicon during an initial step in which an ingot is grown. It is, therefore, extremely difficult to avoid problems due to impurities, such as the contamination of wafers or the occurrence of crystal defects, in a device fabrication process using silicon wafers.

Gettering techniques are known for achieving good device characteristics by removing such impurities or incidental crystal defects from an element forming region of a wafer. One gettering technique is called an IG (intrinsic gettering) technique in which impurity gettering is implemented by forming crystal defects in the interior of a silicon wafer and absorbing the impurities therein.

A typical example of the process involved in a known IG technique is explained below. In the process, prior to or in part during wafer processing, a silicon wafer is exposed to the following three stages or steps of heat treatment in a nitrogen gas atmosphere.

Step (1) involves heat treatment for 30 to 60 minutes at 1100°C. In step (1), oxygen impurities are removed from a wafer surface by outward diffusion to form a defect-free zone on the surface. Step (2) involves heat treatment for several hours at 700°C. In step (2), nuclei of oxygen precipitation are produced in the interior of the wafer. Step (3) involves heat treatment for 1 hour at 1000°C. In step (3), oxygen is attracted to the nuclei of oxygen precipitation with an increase in the number of associated small defects, thereby increasing the ability of gettering.

The high-density defect-layer region in the wafer in which oxygen is precipitated through the above-described steps, is called an IG layer and a surface defect-free zone is called a DZ (denuded zone).

Manufacturing processes for silicon semiconductor devices, particularly wafer processes, encounter the problem of contamination due to metallic impurities. The contamination due to metallic impurities may cause increases in leakage current at pn junctions or an incidental deterioration in voltage-resistance characteristics, or otherwise a decrease in carrier lifetimes. Impurities which have particularly serious effects are heavy metal impurities such as iron (Fe), chromium (Cr), copper (Cu) and nickel (Ni). In the case of an image sensor employing a semiconductor device such as a CCD (charge coupled device), junction leakage currents due to impurities in a photodetector region increase dark current and decrease device performance. In DRAMs, increases in junction leakage currents will require shorter refreshing times and may cause imperfect refreshing.

The above-described known IG technique which serves the function of removing such heavy metal impurities from an active element region, effectively works on Cu, Ni or the like, but is not sufficiently effective on Fe and Cr.

To improve the performance of semiconductor devices, it is desired to establish a reliable gettering technique for the above-mentioned heavy metal impurities.

An embodiment of the present invention can provide a method of gettering heavy metal impurities, which cannot be satisfactorily removed by a conventional intrinsic gettering technique, from a region adjacent to the surface of a silicon wafer.

An embodiment of the present invention can provide a manufacturing method in which prevention or suppression of leakage current in a semiconductor device employing a p-type silicon substrate is contemplated, particularly a manufacturing method which makes it possible to decrease dark current in a CCD-type image sensor.

An embodiment of the present invention provides a method of gettering heavy metal impurities, such as iron and chromium, which have been difficult to remove by a conventional intrinsic gettering method.

An embodiment of the present invention can be applied, for example, to CCD fabrication. As is known, if a CCD is used as an image sensor, heavy metal impurities introduced into the silicon substrate increase the level of an output signal of dark current, thus leading to a deterioration in sensor characteristics. An embodiment of the present invention can be particularly effective when applied to gettering subsequent to wafer processing during CCD fabrication.

In accordance with an embodiment of the present invention, a method of gettering heavy metal impurities from a p-type silicon substrate comprises the steps of subjecting the silicon substrate to heat treatments to form an intrinsic gettering layer having a large density of crystal microdefects in the interior of the substrate, then carrying out wafer processes required to manufacture semiconductor devices, other than the formation of a metallic wiring layer, and subsequently heating the silicon substrate to approximately 200°C and simultaneously irradiating the substrate with light rays, thereby absorbing the heavy metal impurities into the inner intrinsic gettering layer.

Reference is made, by way of example, to the accompanying drawings, in which:-

Fig. 1 is a graphic representation illustrating the result obtained when Fe concentration is measured by a DLTS (deep level transient spectroscopy) method after a p-type silicon wafer has been exposed to heavy metal contamination;

Fig. 2 is a graphic representation showing the results obtained by measuring variations in the surface Fe concentration of different p-type silicon wafer samples under various conditions including the presence or absence of Fe contamination, the presence or absence of an intrinsic gettering (IG) layer and differences in gettering processes;

Fig. 3 is a diagrammatic view showing a crystalline structure obtained by introducing Fe impurities into a p-type silicon crystal, and shows that Fe may form either a Fe-B pair or interstitial Fei;

Fig. 4 is a diagrammatic view which serves to illustrate basic features of a gettering method according to an embodiment of the present invention;

Figs. 5(a) to 5(d) are graphic representations showing variations in DLTS measurement data which are obtained by changing gettering methods after a p-type silicon substrate has been exposed to Fe contamination;

Fig. 6 is a graphic representation showing the relationship between the diffusion coefficient of Fei and temperature; and

Fig. 7 shows in flow-chart of semiconductor-device manufacturing processes used to form a semiconductor device and in which an embodiment of the present invention is applied.

For the purposes of explanation only, references will be made to CCD devices.

In an investigation of the possible cases of increase in dark current in the photo-detection region of a CCD, a p-type silicon wafer passed through the same processes as provided when forming such a CCD was subjected to a DLTS measurement to examine the state of the wafer with regard to heavy metal contamination.

It was found that iron (Fe) and boron (B) as an acceptor were present in the state of a Fe-B pair in the silicon (Si).

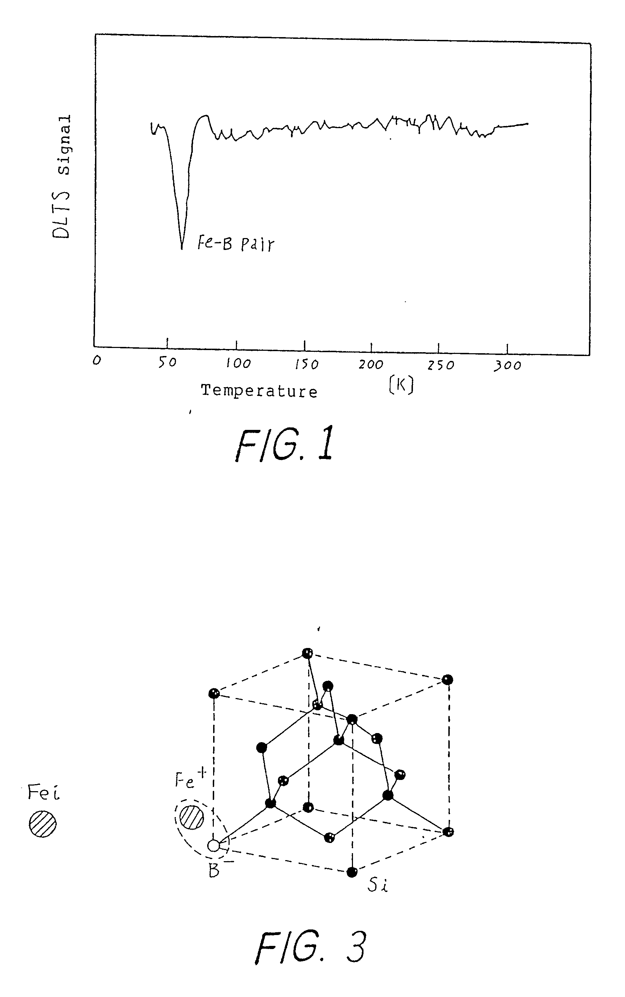

Fig. 1 is a graphic representation showing the results of measurement utilising a DLTS method. In a general DLTS measurement method, reverse pulse voltage is applied to a pn junction and the resulting capacitance is measured at times $t_1$ and $t_2$ after the application of the reverse pulse voltage. The measured capacitance difference $\Delta C$ is plotted with respect to temperature. For actual measurement, the temperature was changed from 40 K to 320 K, and sampling times $t_1 = 200$ μs and $t_2 = 2$ ms were selected. The vertical axis in Fig. 1 corresponds to a unit proportional to the aforesaid $\Delta C$. The illustrated abrupt decrease in signal level is caused by contamination due to impurities and its peak value is proportional to the concentration of the impurities. The peak is in the neighbourhood of 60 K, and was found to correspond to the above-mentioned Fe-B pair by correlation with measurement data obtained by infrared absorption analysis, ESR (electron spin resonance) analysis or the like.

The characteristics of heavy metal impurities which are contained in silicon are disclosed in the following documents, and detailed explanation is omitted:-

(1) "Transition Metals in Silicon" by Eicke R. Weber; Appl. Phys., A30, 1-22 (1983); and

(2) "The Properties of Iron in Silicon" by K. Graff and H. Pieper; J. Electrochem. Soc., Vol. 128, No. 3 (1981).

An experiment was also effected to determine what degree of contamination due to heavy metal could be removed from the surface active region of a silicon wafer by the conventional IG technique described above.

The following three sample groups were prepared:-

Group No. 1: Although heat treatments for forming an IG layer on a wafer are performed, the wafer is not exposed to intentional Fe contamination;

Group No. 2: Heat treatments for forming an IG layer on a wafer are not performed and the wafer is exposed to Fe contamination;

Group No. 3: After heat treatments for forming an IG layer on a wafer have been performed, the wafer is exposed to Fe contamination.

In the aforesaid experiment, a B-doped p-type silicon wafer having a resistivity of 10 Ω cm and an oxygen-impurity concentration of 1.70 to 1.87 x 10 cm$^{-3}$ was used for the samples.

The heat treatments for IG-layer formation were conducted in three steps:- at 1000°C for 30 minutes, at 650°C for six hours, and at 1000°C for 30 minutes.

To provide Fe contamination, a sample wafer was dipped in a 60% HNO$_3$ solution containing 500 ppm of Fe ions. The surface concentration of the Fe impurities was 5.0 x 10$^{13}$ cm$^{-2}$.

Sample wafers of each group were finally subjected to a heat treatment of 1000°C for 1 hour to diffuse Fe in the interior of the wafers, thereby effecting gettering.

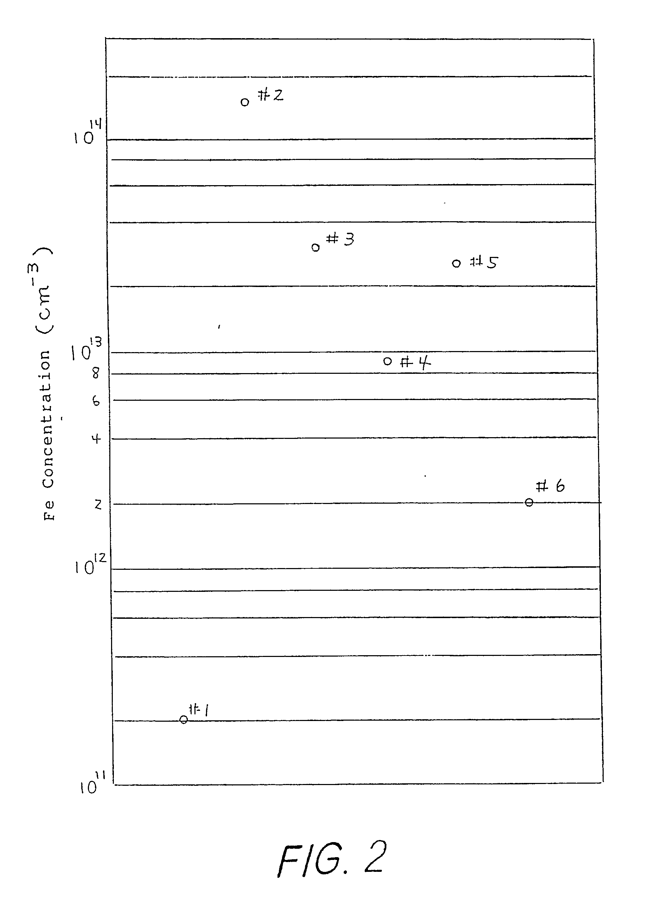

Fig. 2 shows the results. As can be seen from Fig. 2, the Fe concentration of Group No. 2 exposed to Fe contamination and devoid of an IG layer is about three orders of magnitude greater than that of Group No. 1 which was not exposed to Fe contamination. In contrast, the Fe concentration of Group No. 3 exposed to Fe contamination and provided with an IG layer is as low as approximately one-fifth of the Fe concentration of Group No. 2. However, Fe concentration of Group No. 3 is approximately two orders of magnitude greater in Fe concentration than Group No. 1, which means that ordinary IG methods do not provide satisfactory gettering.

The width (thickness) of a denuded zone (DZ) provided at a wafer surface for Group No. 3 was found to be approximately 12 $\mu$m, and the concentration of crystal defects in the IG layer is 5.0 x $10^5$ cm$^{-2}$. It is to be understood, therefore, that effective IG treatment was achieved with respect to Group No. 3. These findings demonstrate that Fe which is heavy metal is extremely difficult to getter by ordinary IG techniques.

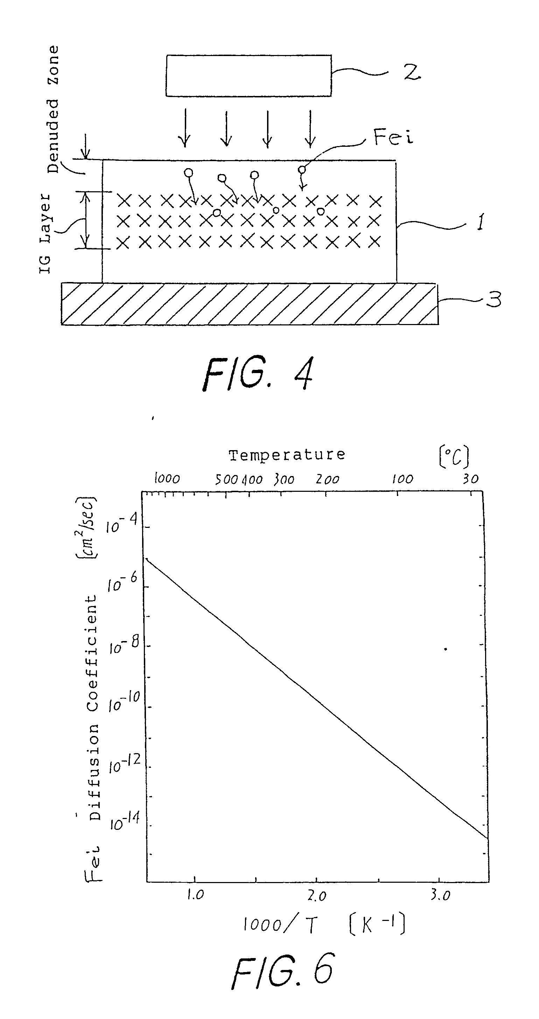

As described in detail in the above-mentioned documents (1) and (2), it is known that Fe in a p-type (B-doped) Si crystal can effectively assume two forms, which exhibit properties of two different kinds, in accordance with activation energy values. One kind of Fe forms interstitial Fe (Fei) and the activation energy is represented as Ev + 0.40 eV. The other kind of Fe forms substitutional Fe which is paired with a dopant B to form Fe-B, and the activation energy is represented as Ev + 0.10 eV. Fig. 3 is a diagrammatic view illustrating a crystal structure of silicon in which the aforesaid two kinds of Fe are present. In the drawing, a substitutional Fe is shown surrounded by a broken line and an interstitial Fei is shown at a location away from the substitutional Fe.

In general, both Fei and Fe-B forms coexist and the total amount of Fe does not vary, but the ratio of Fei to Fe-B forms varies due to a variety of factors such as the hysteresis of heat treatments and the elapsed time thereafter. More specifically, when the wafer is quenched after heat treatments, a major part of the Fe assumes the interstitial Fei form. When a certain time period passes after the quenching, interstitial Fei is gradually paired with B.

The inventors have had the insight that the presence of Fe-B pairs hinders Fe concentration in a denuded zone from being sufficiently reduced by conventional IG technique and that it is possible to reduce the Fe concentration in the denuded zone by reducing the number of Fe-B pairs and substituting interstitial Fei for such pairs. This can be achieved in accordance with an embodiment of the present invention as explained below.

Fig. 4 is a diagrammatic view which serves to illustrate basic features of an embodiment of the present invention. A p-type silicon wafer 1 is placed on a heating pad 3, and a light source 2 is disposed above the wafer 1. The light source 2 may be a white light source such as a halogen lamp or an ultraviolet light source. Since light has energy sufficient to dissociate Fe-B pairs, particularly large power is not needed. For example, it is sufficient that a 50-W light source be converged by a reflection mirror.

After the same heat treatments for forming an IG layer as those applied to samples of Group No. 3 (1000°C, 30 minutes; 650°C, 6 hours; and 1000°C, 30 minutes) and after similar Fe contamination treatment (the dipping of each wafer sample in a 60% HNO$_3$ solution containing 500 ppm of Fe ions), the following gettering treatments were performed for three further sample groups:-

Group No. 4: Heated at 200°C for 6 hours;

Group No. 5: Irradiated by ultraviolet rays for six hours; and

Group No. 6: Heated at 200°C and simultaneously irradiated by ultraviolet rays for six hours.

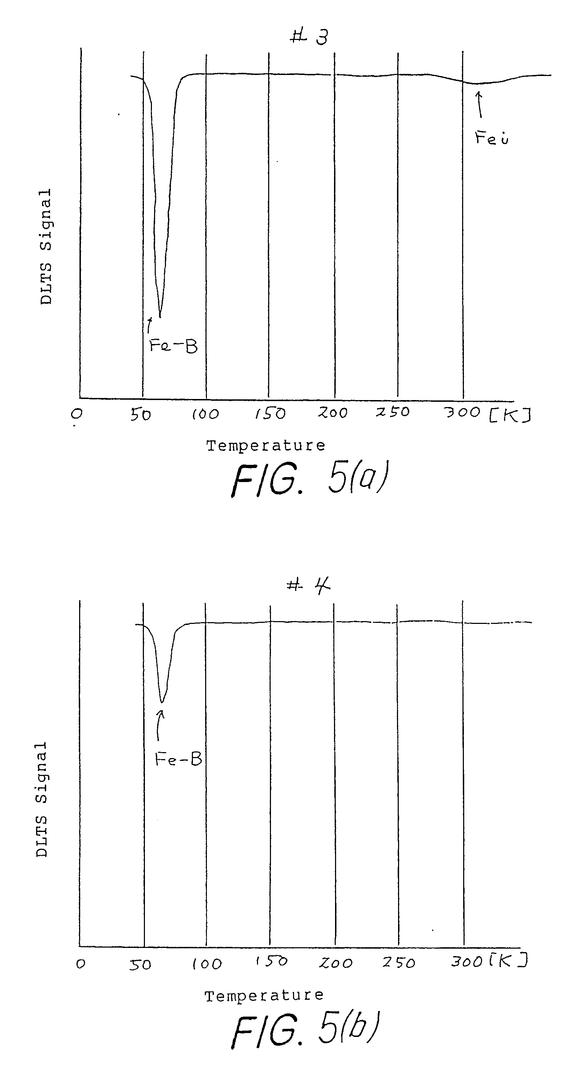

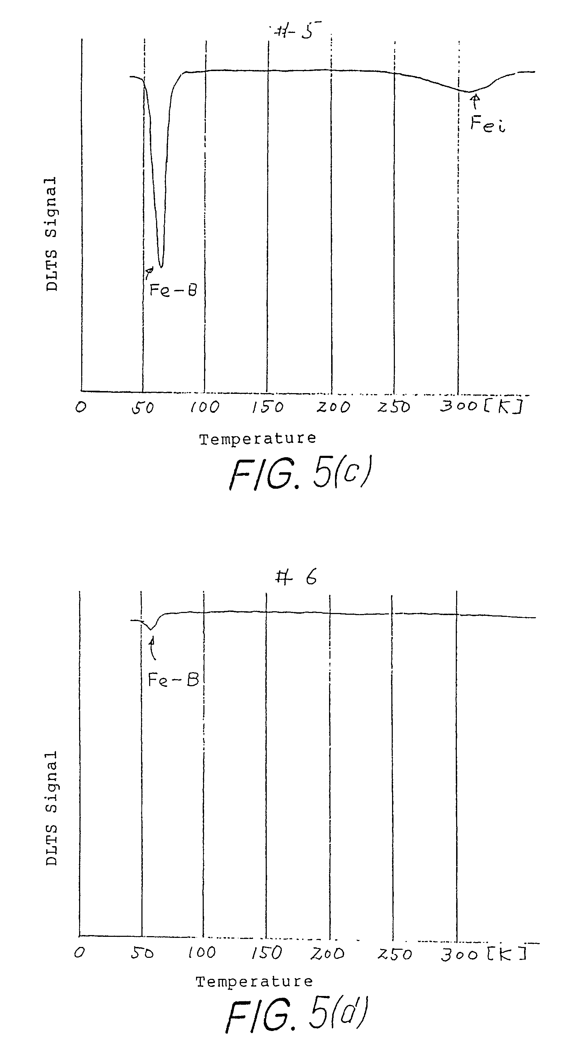

The results are shown in Fig. 2, and DLTS characteristics of the respective groups 3 to 6 are shown in Figs. 5(a) to 5(d).

As can be seen from Fig. 2, the Fe concentration for Group No. 4 is as low as approximately one-third of that for Group No. 3. The Fe concentration for Group No. 5, exposed to ultraviolet rays only, is substantially the same as that for Group No. 3. This shows that, although the total amount of Fe does not change, the Fe concentration of Fe-B pairs decreases and that of interstitial Fei increases. The IG treatment applied to Group No. 6 is the most effective in that the Fe concentration is as low as approximately one-tenth the Fe concentration for Group No. 3. No crystal defect was observed in a wafer sample denuded zone.

The required heating temperature and time can be determined in consideration of the diffusion coefficient D of Fei which is given by the following equation, which is described in the above-mentioned document (1):-

$$D = 1.3 \times 10^{-3}\exp(-0.68[eV]/kT) \text{ cm}^2/\text{sec.}$$

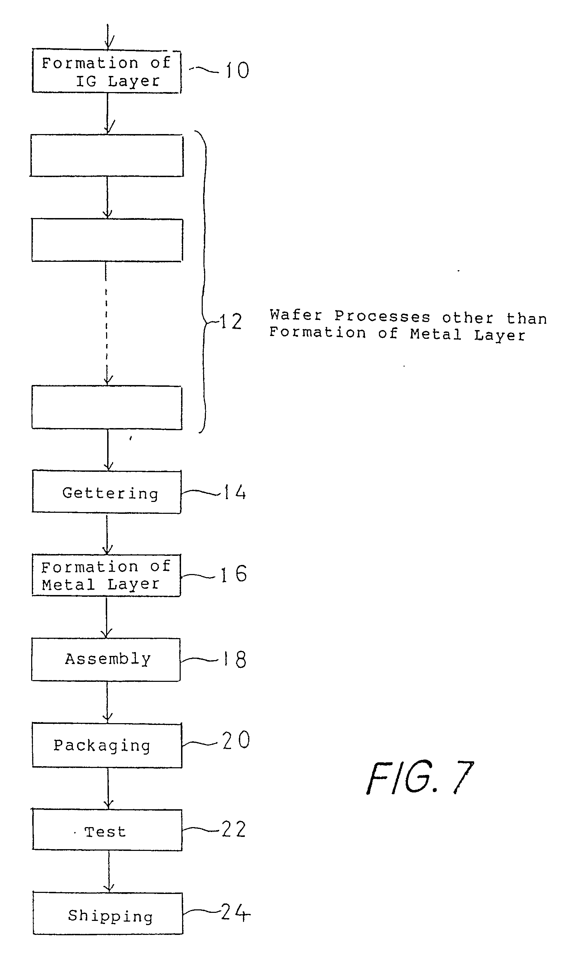

This equation is illustrated in Fig. 6 in a graphic representation, and the following relationships can be obtained:-

$$D = 5.7 \times 10^{-15} \text{ cm}^2/\text{sec (at 25°C)}$$
$$D = 7.5 \times 10^{-11} \text{ cm}^2/\text{sec (at 200°C)}.$$

To assure a diffusion length x of 10 $\mu$m (which corresponds to a width (thickness) of a denuded zone DZ) 10 um should be substituted for x in the formula $x = \sqrt{Dt}$ (t: diffusion time), giving:-

$$t = 4.9 \times 10^4 \text{ h (at 25°C)}$$
$$t = 3.7 \text{ h (at 200°C)}.$$

Therefore, if the required processing time is to be reduced to within reasonable limits, it is desirable that the required heating temperature be higher than about 150°C (processing time is approximately 28 hours at 150°C).

However, since the amount of Fe precipitation gradually increases as heating temperature is increased, it is not desirable that 220°C be exceeded. Once Fe precipitates are produced, they are not reversibly converted to interstitial Fei even by light irradiation and it is therefore impossible to getter the Fe precipitates. When these conditions are considered, it is desirable that the heating temperature is selected to be at or around 200°C. It is practically sufficient that the heating time be four hours or more.

It is desirable that a gettering treatment according to an embodiment of the present invention be carried out prior to metallisation for forming a wiring pattern of aluminium throughout the entire wafer processes. This is because, once a metal layer is formed on a wafer surface, the effect of light irradiation employed according to an embodiment of the present invention may be impaired.

Fig. 7 is a flow chart illustrating a semiconductor-device manufacturing process in which the techniques in accordance with an embodiment of the present invention are applied.

In step 10, a silicon wafer is subjected to heat treatments as above for the purpose of forming an IG layer. Subsequently, the wafer is passed through wafer processes 12 including a number of process steps other than a metal layer forming step 16. In accordance with an embodiment of the present invention, a gettering step 14 is performed before step 16. At this stage light irradiation can be effectively carried out. It is desirable that, after gettering has been completed, high-temperature processing steps should not be performed. Subsequent steps such as metal layer forming step 16, an assembly step 18, a packaging step 20, a test step 22 and a shipping step 24 are substantially conventional.

The concentration of heavy metal impurities in a normal Si crystal (CZ, FZ) is reported to be on the order of $10^9$ cm$^{-3}$. However, a silicon wafer may be exposed to contamination up to $10^{10}$ to $10^{14}$ cm$^{-3}$ in wafer processes. Accordingly, it is more effective to perform the gettering treatment according to an embodiment of the present invention in a final or late stage of the wafer processing.

When an embodiment of the present invention was applied to a CCD-type image sensor, the concentration of Fe-B was improved to $1 \times 10^{11}$ cm$^{-3}$ or lower, from a level of $8 \times 10^{11}$ cm$^{-3}$ found with the prior art. The incidence failure of output signals to satisfy dark current (DS) requirements was reduced by a factor of 10.

While the explanation has reference to Fe which is one kind of heavy metal impurity, embodiments of the present invention may be likewise applied to Cr impurities, since Cr also forms a Cr-B pair.

It will be appreciated from the foregoing that embodiments of the present invention make it possible to effectively reduce dark current in a CCD-type image sensor which handles analog signals.

However, embodiments of the present invention are not limited to the above-described range of applications. Embodiments of the invention can be effectively applied to the fabrication of ICs including MOS transistors or bipolar transistors within the object of reducing leakage current. In particular, embodiments of the present invention can be applied in relation to DRAMs to provide marked effects, since the power consumption of DRAMs can be reduced by preventing leakage current during their refreshing operations. When p-type silicon substrates are utilised, the above-described techniques such as the formation of an IG layer and a gettering treatment may be similarly applied.

An embodiment of the present invention provides a method of gettering heavy metal impurities from p-type silicon substrates which comprises

(a) forming an intrinsic getting layer covered by a surface denuded zone in the silicon substrate by subjecting the substrate to heat treatments which form the intrinsic getting layer with a density of crystal microdefects which is large compared to the density of crystal microdefects in the denuded zone; and

(b) subsequently performing a gettering step of heating the silicon substrate to a predetermined temperature and simultaneously irradiating the substrate with light rays.

The predetermined temperature is selected to be within the temperature range 150°C to 220°C, preferably around 200°C.

Between (a) and (b) most of the required wafer processes, other than the step of forming a metal layer, may be performed.

## Claims

1. A method of gettering heavy metal impurities combined with acceptor impurities in a silicon substrate, said method comprising steps:-

(a) forming an intrinsic gettering layer covered with a surface denuded zone by subjecting said substrate to heat treatments, the intrinsic gettering layer having a density of crystal microdefects larger than the density of crystal microdefects in the denuded zone; and

(b) heating said substrate to a predetermined temperature and simultaneously irradiating said substrate with light rays, said predetermined temperature being selected to be lower than the precipitation temperature of said heavy metal impurities and high enough for the heavy metal impurities to diffuse into said intrinsic gettering layer, the energy level of said light being selected to be sufficient to dissociate the heavy metal impurities from the acceptor impurities.

2. A method as claimed in claim 1, wherein said predetermined temperature is in the 150°C to 220°C, preferably around 200°C.

3. A method as claimed in claim 1 or 2, wherein said heavy metal impurities are iron or chromium.

4. A method as claimed in claim 1, 2 or 3, wherein, between steps (a) and (b), the substrate surface on which semiconductor device elements are to be formed is subjected to most of the processes required for such formation, other than formation of a metal layer.

5. A method of gettering heavy metal impurities as claimed in claim 4, further comprising, after step (b), the formation of the metal layer, for wiring.

6. A manufacturing method for a semiconductor device using a silicon substrate, employing a method of gettering as claimed in any preceding claim.

EP 0 398 216 A2

FIG. 1

FIG. 3

FIG. 2

FIG. 4

FIG. 6

# 3

Fe-B

Feᵢ

FIG. 5(a)

# 4

Fe-B

FIG. 5(b)

EP 0 398 216 A2

#-5

*FIG. 5(c)*

# 6

*FIG. 5(d)*

```
         ┌──────────────┐
         │ Formation of │ ∿ 10
         │   IG Layer   │
         └──────┬───────┘
                │
                ▼
         ┌──────────────┐ ┐
         │              │ │
         └──────┬───────┘ │
                │         │
                ▼         │
         ┌──────────────┐ │
         │              │ │   ∿12   Wafer Processes other than
         └──────┬───────┘ │         Formation of Metal Layer
                ┆         │
                ▼         │
         ┌──────────────┐ │
         │              │ │
         └──────┬───────┘ ┘
                │
                ▼
         ┌──────────────┐
         │  Gettering   │ ∿14
         └──────┬───────┘
                │
                ▼
         ┌──────────────┐
         │ Formation of │ ∿16
         │ Metal Layer  │
         └──────┬───────┘
                │
                ▼
         ┌──────────────┐
         │  Assembly    │ ∿18
         └──────┬───────┘
                │
                ▼
         ┌──────────────┐
         │  Packaging   │ ∿20
         └──────┬───────┘
                │
                ▼
         ┌──────────────┐
         │ · Test       │ ∿22
         └──────┬───────┘
                │
                ▼
         ┌──────────────┐
         │  Shipping    │ ∿24
         └──────────────┘
```

*FIG. 7*